(19) Europäisches Patentamt
European Patent Office
Office européen des brevets

(11) **EP 1 681 262 B1**

(12) **EUROPEAN PATENT SPECIFICATION**

(45) Date of publication and mention
of the grant of the patent:
**30.03.2016 Bulletin 2016/13**

(51) Int Cl.:
***H01L 21/263*** (2006.01)

(21) Application number: **04793760.2**

(22) Date of filing: **08.10.2004**

(86) International application number:
**PCT/RU2004/000396**

(87) International publication number:
**WO 2005/050697 (02.06.2005 Gazette 2005/22)**

(54) **METHOD FOR FORMING WAVY NANOSTRUCTURES**

VERFAHREN ZUR HERSTELLUNG VON WELLENFÖRMIGEN NANOSTRUKTUREN

PROCEDE DE FORMATION DE NANOSTRUCTURES ONDULEES ORDONNEES

(84) Designated Contracting States:
**AT BE BG CH CY CZ DE DK EE ES FI FR GB GR
HU IE IT LI LU MC NL PL PT RO SE SI SK TR**

(30) Priority: **10.10.2003 RU 2003129927**

(43) Date of publication of application:
**19.07.2006 Bulletin 2006/29**

(73) Proprietor: **Wostec, Inc.
San Francisco, CA 94127 (US)**

(72) Inventors:
• **SMIRNOV, Valery Konstantinovich
Yaroslavl, 150003 (RU)**
• **KIBALOV, Dmitry Stanislavovich
Yaroslavl, 150051 (RU)**

(74) Representative: **von Füner, Nicolai et al
v. Füner Ebbinghaus Finck Hano
Patentanwälte
Mariahilfplatz 2&3
81541 München (DE)**

(56) References cited:
EP-A2- 0 317 952       RU-C1- 2 141 699
RU-C1- 2 204 179       US-B1- 6 274 007

• **A KAREN ET AL: "Quantitative investigation of
the O2<+>-induced topography of GaAs and
other III-V semiconductors: an STM study of the
ripple formation and suppression of the
secondary ion yield change by sample rotation",
SURFACE AND INTERFACE ANALYSIS, vol. 23,
no. 7-8, 1 July 1995 (1995-07-01) , pages 506-513,
XP55016985, ISSN: 0142-2421**
• **SMIRNOV V K ET AL: "Wave-ordered structures
formed on SOI wafers by reactive ion beams",
NUCLEAR INSTRUMENTS & METHODS IN
PHYSICS RESEARCH, SECTION - B:BEAM
INTERACTIONS WITH MATERIALS AND ATOMS,
ELSEVIER, AMSTERDAM, NL, vol. 147, no. 1-4, 1
January 1999 (1999-01-01), pages 310-315,
XP004196320, ISSN: 0168-583X, DOI:
10.1016/S0168-583X(98)00610-7**

## Description

## Field of the Invention

The invention relates to the methods for forming wavy (wavelike) patterns as a relief structure with a period of about 100 nm and less on the substrates' surface with ion fluxes.

## State of the Art

The method of forming wavelike patterns upon the silicon surface as a nanorelief structure (application for the Russian Patent RU99124768, whose corresponding European application has been published as EP 1 104 011 A1) is known:

> The silicon is sputtered with a homogeneous ion flux of molecular nitrogen $N_{2+}$ until a periodic wavelike nanostructure with the nanostructure waves crests' orientation perpendicular to a plane of ion incidence is formed;
> wherein first, the parameters defining the geometry of emerging wavelike nanostructure and the sputtering depths $D_m$ and $D_F$ corresponding to the commencement and completion of the growth of a nanostructure wave amplitude are selected: an ion energy, an angle of ion incidence upon the silicon's initial surface, the silicon's temperature and a depth of ion penetration into the silicon - are based upon a wavelength of the said nanostructure.

Thus, the analogue makes use of $N_2^+$-Si system to form a wavelike nanostructure.
It is known that the gallium arsenide sputtering with $O_2^+$ ions ($O_2^+$-GaAs system) leads to formation of a wavelike nanostructure (Karen A., Nakagawa Y., Hatada M., Okino K., Soeda F., Ishitani A., Quantitave Investigation of the O2+- InducedTopography of GaAs and other III-V Semiconductors: an STM Study of the Ripple Formation and Suppression of the Secondary Ion Yield Change by Sample Rotation. - Surf. and Interf. Anal., 1995, v. 23, p. 506-513).
A. Karen et al. (A Karen et al.: "Quantitative Investigation of the O2+-induced Topography of GaAs and Other III-V Semiconductors: an STM Study of the Ripple Formation and suppression of the Secondary Ion Yield Change by Sample Rotation", SURFACE AND INTERFACE ANALYSIS, vol. 23, no. 7-8, 1 July 1995, pages 506-513) refers to roughening procedures including the early stage of the $O_2^+$-induced ripple formation of gallium arsenide.
V. K. Smirnov et al. (V. K. Smirnov et al.: "Wave-ordered structures formed on SOI wafers by reactive ion beams", NUCLEAR INSTRUMENTS & METHODS IN PHYSICS RESEARCH, SECTION - B: BEAM INTERACTIONS WITH MATERIALS AND ATOMS, ELSEVIER, AMSTERDAM, NL, vol. 147, no. 1-4, 1 January 1999, pages 310-315) refers to the dependence of wave-ordered structure formation during a low-energy ion bombardment of silicon in a one step process.
A useful property of the said nanostructure is a sufficiently high value of its aspect ratio (i.e. the ratio of relief amplitude to wavelength or a wave period). However, a degree of the ordering and planarity of a wavelike nanostructures being formed in $O_2^+$-GaAs system is low.
A technical result of the invention consists in a substantial improvement of the ordering of a wavelike relief structure being formed.
This is achieved through the use of the gallium arsenide instead of the silicon sputtered with $N_2^+$-ion flux (as described in the analogue RU99124768) or, in other words, instead of $N_2^+$- Si system $N_2^+$- GaAs system is used. Thus, the gallium arsenide's irradiation with $N_2^+$ leads to the formation of a wavelike nanostructures possessing a quality of the natural ordering of a high degree.
Preferably, the layers of amorphous gallium arsenide should be as gallium arsenide.
Preferably, the layers of amorphous gallium arsenide should be formed by the method of the gallium arsenide's magnetron sputtering.
Preferably, the $N_2^+$- ion incidence angle should be selected in 55° to 60° range relative to the normal of a GaAs initial surface.
Preferably, the $N_2^+$- ion energy should be selected in 6 to 8 keV range.
Preferably, the GaAs should be sputtered with $N_2^+$- ions up to a depth $D_F$ = 1 micron.
An additional sputtering of a wavelike nanostructure formed in $N_2^+$- GaAs system, is carried out with $O_2^+$ ion flux in a bombardment plane coinciding with the bombardment plane of $N_2^+$ ions in order to increase the amplitude of a wavelike nanostructure.
Preferably, the energy and the angle of bombardment with $O_2^+$ ions in the additional sputtering should be selected in such a way that the wavelengths in $N_2^+$-GaAs and $O_2^+$-GaAs systems are equal.
Preferably, the amplitude growth of a wavelike nanostructure under the additional sputtering with $O_2^+$ ions should be controlled by the secondary-emission signal.
Preferably, the signals of secondary electron, ion or photon emission should be used as a secondary-emission signal.
Preferably, the additional irradiation with $O_2^+$ ions should be carried out only until the moment when the secondary-emission signal is saturated.
It is known that while the silicon is sputtered with a flux of ions of the molecular oxygen ($O_2^+$-Si system) a wavelike relief structure is also being formed (Vajo J. J., Doty R. E., Cirlin E. H. Influence of O2+ energy, flux and fluency on the formation and growth of sputtering-induced ripple topography on silicon. - J. Vac. Sci. Technol.A, 1996, v. 14, No 5, p. 2709-2720). By means of the scanning electron microscopy (SEM) the authors of the present invention have ascertained that at a certain depth of the silicon's sputtering $D_m$ corresponding to the commencement of an intensive growth of the amplitude of a wavelike relief structure a low-amplitude relief is being formed in $O_2^+$-Si system which is notable for an increased ordering or for wider waves as compared with $N_2^+$-Si system. However, while a further sputtering with the oxygen ions in $O_2^+$-Si system takes place with the growth of a waves' amplitude the relief 's ordering and its planarity considerably deteriorate. On the contrary, a wavelike relief structure formed in $N_2^+$-Si is notable for a high degree of planarity lasting out up to the sputtering depths equal to $3*D_F$.

A technical result of the second invention also consists in an improvement of the ordering of a wavelike relief structure being formed.

This is achieved through the carrying out of the silicon sputtering in two stages. First, a low-amplitude wavelike nanostructure with an increased ordering at the sputtering depth $D_m$ is formed with $O_2^+$ ion flux in $O_2^+$-Si system and thereupon a further silicon sputtering with $N_2^+$ ions in $N_2^+$+-Si system is carried out until the amplitude of a wavelike nanostructure at the sputtering depth $D_F$ is saturated. Meanwhile the bombardment planes for $O_2^+$ and $N_2^+$ ions coincide and the energy and the angle of ion bombardment are selected in such a way that the wavelengths of the wavelike relief structure in $O_2^+$-Si and $N_2^+$-Si are equal.

Preferably, the layers of amorphous silicon should be used as silicon.

Preferably, the formation of a wavelike nanostructure should be controlled by the secondary-emission signals.

On the basis of $N_2^+$-Si system research the authors of the present invention have ascertained that a preliminary directional polishing of the silicon's surface in a direction of the waves' crests of a wavelike relief structure formed thereupon considerably increases a degree of the relief 's orientation, i.e. its ordering.

A technical result of the invention also consists in an improvement of the ordering of a wavelike relief structure being formed.

This is achieved through the carrying out of a preliminary directional polishing of the silicon surface, thereupon a wavelike relief structure in $N_2^+$-Si system is formed in such a way that an orientation of the waves' crests coincide with the polishing's direction.

Preferably, the abrasives consisting of small particles, such as aluminum, silicon and chrome oxides should be used for a directional polishing.

A device containing the plasma electrode with an apertures' matrix for forming an ion beams' matrix out of the general plasma is known (K.L. Scott, T.-J. King, M.A. Lieberman, K.-N. Leung "Pattern generators and microcolumns for ion lithography"- Journal of Vacuum Science and Technology B, v. 18 (6), 2000, pp. 3172-3176; K.-N. Leung, H.Y. Lee, V. Ngo, N. Zahir "Plasma formed ion beam projection lithography system"; Patent US6486480).

The analogue's deficiency is an inadequate minimal size of the formed pattern.

A device for forming patterns on the substrates' surface (RU2180885) containing a former of the matrix of oblique linear ion beams on the basis of a plasma electrode with the matrix of linear apertures positioned in conformity with the required disposition of the arrays of nanolines on the silicon surface and a precision table for a transference of the substrate across the sheet ion beams is known.

A deficiency of the prototype is a complexity of manufacturing the microsystems of deviation and focusing of the sheet ion beams.

A technical result is a simplification of manufacturing of the known device by eliminating the microsystems for deviation and focusing of the sheet ion beams and forming an array of nanolines at a normal incidence of the sheet beams upon the silicon surface.

This is achieved by the use of a former of the matrix of sheet ion beams that assures a normal incidence of beams upon the silicon surface. This makes the device be closer to the analogue. However, the device's purpose - a formation of coherent wavelike nanostructures upon silicon surfaces with a much smaller period than a width of an ion beam - makes it different from the analogue meant for an ion beam projection lithography, i.e. forming the lines in the resist with a width comparable with a diameter of an ion beam.

The principle distinction is in the matrix of sheet beams as compared to the matrix of circular beams and in a movement of a precision table accomplishing the transfer of the substrate across the sheet beams.

Preferably, the width of sheet ion beams should amount to 0.5 micron at the ion energy of 5 keV.

Preferably, the precision table for the substrate should provide for a transfer of the substrate at a velocity determined by the following relation:

$$V=(L_L \cdot Y \cdot A)/(p \cdot D_F \cdot N_A \cdot e) \quad ,$$

where $I_L$ is a linear current densty of sheet ion beam, A/cm;
$Y$ is a sputtering yield as calculated in respect to one atom of nitrogen;
$A$ is a molar mass of the silicon, gram/mole;
$\rho$ is the density of silicon, g/cm$^3$
$D_F$ is a coherent wavelike structure forming depth, cm;
$N_A$ is the Avogadro number, $6.022 \cdot 10^{23}$ mole-1
$e$ is the electron charge, $1.6 \cdot 10$-19 Kl.

Preferably, the precision table for a substrate should transfer the substrate at a velocity regulated by a secondary electron emission signal from a test cell set up on the precision table.

A device for the substrate polishing substrates in a semi-conductor manufacturing is known (US2002/0142704).

The known device consists of a substrate holder providing for a substrate rotation around its axis and the substrate's plane, an constantly running band upheld by a support in a place where the substrate's surface joins the band, the motors providing for the substrate holder's rotation, devices for supplying a polishing mixture onto the band and for supplying air through the system of apertures in the support for providing of the levitation of the band and even distribution of the substrate pressure on to the band.

A technical result consists in a design alteration of the known device for securing a directed polishing of semi-conducting substrates.

This is achieved by the substrate holder securing a fixed position of the substrate relative to the direction of the band movement.

## BRIEF DESCRIPTION OF DRAWINGS

The inventions are illustrated by the drawings where:

Figure 1A schematically shows a process of forming a coherent low-amplitude wavelike nanostructure upon the gallium arsenide's surface by a sputtering with N2+ ions and the geometry of an individual wave.

Figure 1B shows a coherent wavelike nanostructure upon the gallium arsenide surface with the increased amplitude resulting from an additional sputtering with $O_2+$ ions and the geometry of an individual wave.

Figure 1C shows a SEM-image of a coherent nanostructure formed in $N_2^+$-GaAs with a consequent additional sputtering with $O_2^+$ ions.

Figure 1D shows a SEM-image of a coherent nanostructure formed in $N_2^+$-GaAs with a consequent additional sputtering with $O_2^+$ ions.

Figure 2A shows a SEM-image of a wavelike nanostructure formed in $N_2^+$-Si system.

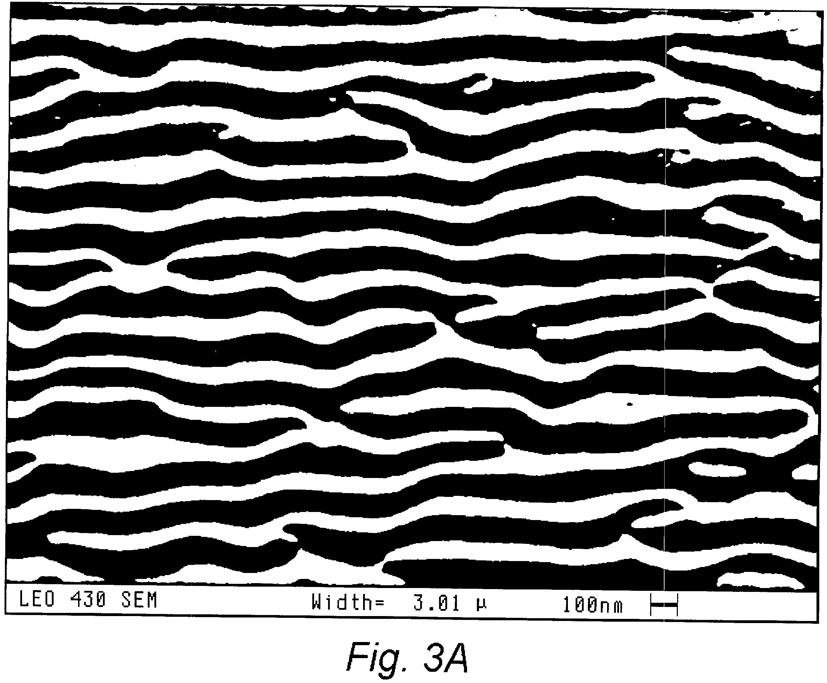

Figure 2B shows a SEM-image of a wavelike nanostructure formed in $O_2^+$-Si system at the depth $D_m$ with a consequent additional sputtering with $N_2^+$ ions. Figure 3A shows a SEM-image of a wavelike nanostructure formed in $N_2^+$-Si system.

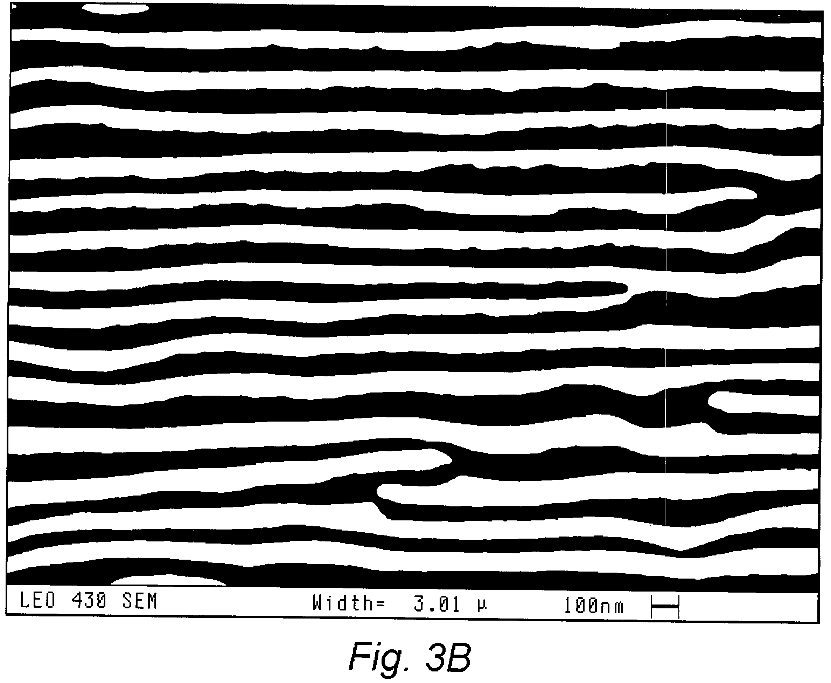

Figure 3B shows a SEM-image of a wavelike nanostructure formed in $N_2^+$-Si system with a preliminary directed surface polishing with GOI paste.

Figure 4A shows a former of the matrix of sheet beams forming beam 1 and containing the matrix of linear apertures 2 in a plasma electrode 3, electrodes 4 for switching on and switching off the sheet beams and insulators 5. Nanostructure 6 is formed upon the silicon substrate 10 with an ion beam 1.

Figure 4B shows a view from above of a plasma electrode 3 (view A), crystal 12 with arrays of nanolines 14.

Figure 4C shows a device for forming coherent wavelike nanostructures on the substrates' surface comprising a former of the matrix of sheet beams 11, permanent magnets 15, a plasma chamber 16 with a system of the nitrogen discharge and exhaustion (not shown on the chart), testing cells 17, a secondary electrodes detector 18, a precision table 19 for a substrate 10, a vacuum chamber 20 with a system of the substrate's exhaust and introduction into a chamber (not shown on the chart), a silicon substrate 10, a computer with interface (not shown on the chart).

Figure 5 shows a device for the directed polishing of the substrates.

## DETAILED DESCRIPTION

An essence of the inventions is expounded through the following examples.

Example 1: An ion sputtering of GaAs samples was carried out in a device designed for layer-by-layer analysis of materials by means of an ion sputtering.

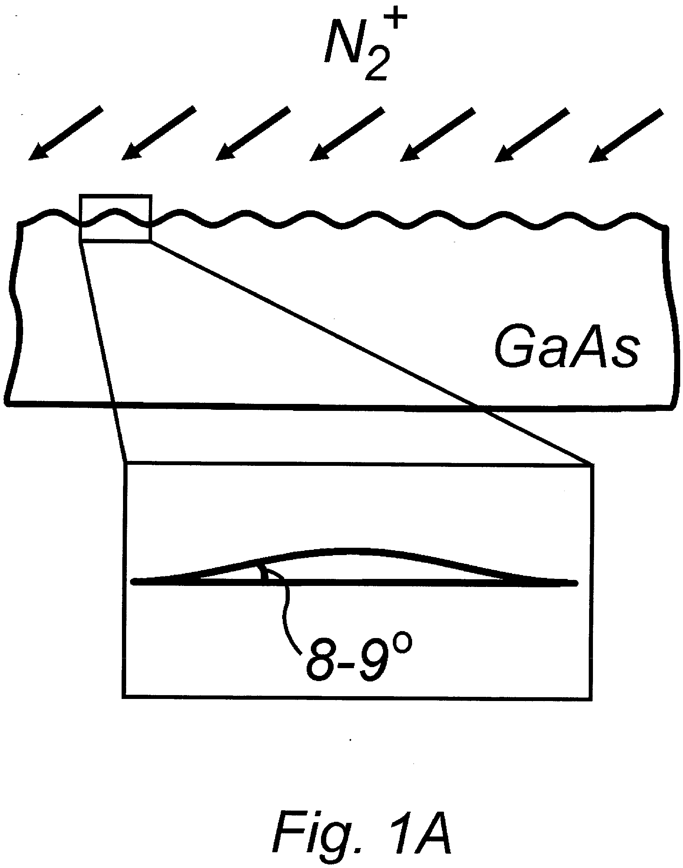

An ion beam was directed in a scan pattern on the sample surface to provide for a homogeneous ion flux. Figure 1A schematically shows a process of forming of a wavelike nanostructure in $N_2^+$-GaAs structure. The chart's plane of Figure 1A coincide with a plane of ion bombardment or with a plane of ion incidence. In a narrow angle range of ion bombardment $\theta=55\text{-}58°$ relative to the normal of a GaAs surface with the ions' energy $N_2+$ E=8 keV at a sputtering depth of $D_F$ being about 1 mkm a stable highly coherent wavelike nanostructure with a wavelength of $\lambda=130$ nm is formed so that the said nanostructure has almost no wave abruptions and a very insignificant number of wave intersections. The waves' crests are oriented perpendicularly relative to a plane of ion bombardment. With an increase of the irradiation dose the said nanostructure does not undergo any significant transformations up to a sputtering depth of 35 micron. An observation through a scanning electron microscope (SEM) of a GaAs crystal chip with a wavelike nanostructure obtained at E=8 keV $\theta=56°$ facilitated an ascertainment of the geometry of an individual wave. The wave amplitude amounted to 13 nm at $\lambda=130$ nm. The waves' slopes are inclined by 8-9° relative to the horizontal. Consequently, the local angles of a bombardment of the waves' slopes are equal to 47° and 65° and a protracted sputtering does not alter these angles.

In $N_2+$-GaAs system a wavelike nanostructure observed through a SEM is not formed at angles $\theta>60°$ (E=8 keV) as well as at the ion energy E<6 keV ($\theta=56°$). At E=6 keV and $\theta=56°$ a wavelike nanostructure with $\lambda=123$ nm is formed. In the absence of a wavelike nanostructure at $\theta>60°$ the solitary cone-shaped formations are observed at the bottom and the slopes of a crater of ion sputtering. At E=8 keV in an angles' range of $\theta=45\text{-}55°$ a low-coherent, low-amplitude periodic nanostructure is formed which undergoes a progressing perturbation when a dose of ion irradiation is increased. A similar progressing perturbation is also typical for $O_2^+$-GaAs and $O_2^+$-Si systems.

No influence of a process of forming a wavelike nanostructure upon an emission of Auger-electrons was detected; *consequently, in situ* registration of this process was impossible.

By means of a SEM observation of a surface of the ion beam etched craters formed by $N_2^+$ ions at a GaAs surface at E=8 keV and $\theta$=55° and at various irradiation doses, a depth of a wavelike nanostructure formation of 1 micron was ascertained.

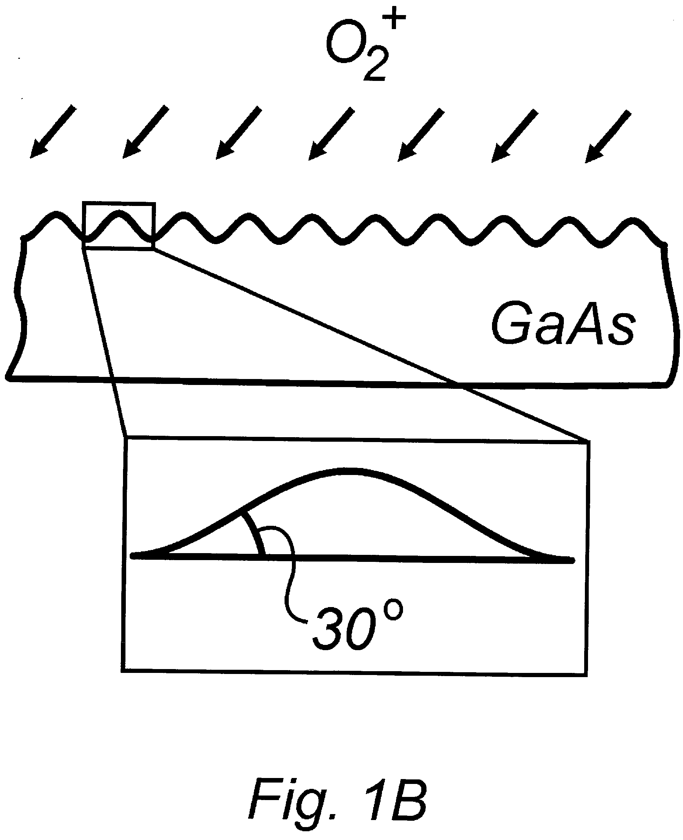

For the purpose of increasing of a wavelike nanostructure amplitude formed in $N_2^+$-GaAs system and for increasing of a tilt angle of the wave slopes the experiments for a two-stage formation of a wavelike nanostructure were carried out. At the first stage a wavelike nanostructure with $\lambda$=128 nm at a sputtering depth of 1.5 micron under conditions of E=8 keV and $\theta$=56.7° was formed in a $N_2^+$-GaAs system, wherein said conditions provided for maximum ordering of the nanostructure. Thereupon a sputtering of this wavelike nanostructure was performed with $O_2^+$ ions under conditions of E=5.5 keV and $\theta$=39° with various ion irradiation doses. The process of an additional sputtering of a wavelike nanostructure is illustrated in Figure 1B. The bombardment planes of $O_2^+$ and $N_2^+$ ions were coincident. A dose of irradiation with $O_2^+$ ions was selected based on the time during which a secondary-emission signal of $GaO^+$ ions reached a saturation point. This emission signal growth and saturation reflects the growth and saturation of a tilt angle of the wave slopes of a nanostructure, as also observed with $As^+$ or $AsO^+$ secondary ions in $O_2^+$-GaAs system.

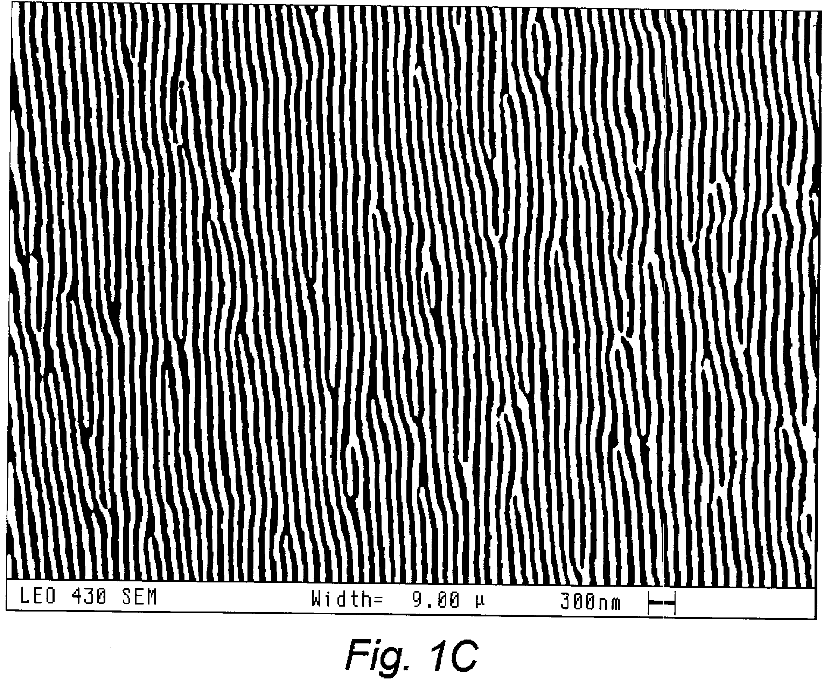

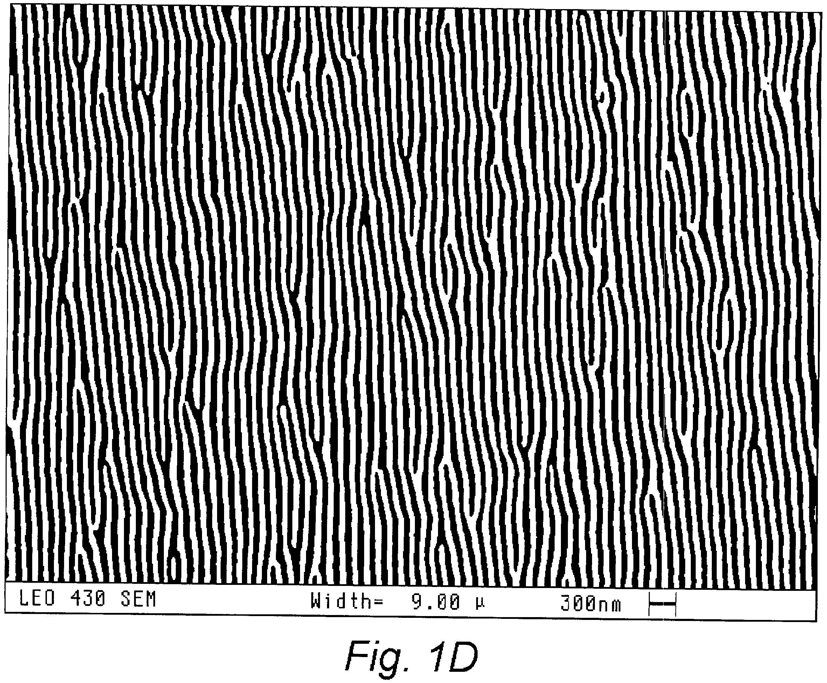

In the experiments the growth of $GaO^+$ emission signal reached saturation within 4 minutes. Figures 1C and 1D show SEM-images of wavelike nanostructures with $\lambda$=123 nm formed as a result of a two-study process under a consequent sputtering with $O_2^+$ ions within 1.5 and 2.5 minutes accordingly. The contrast amplification of a SEM-image in a secondary electron emission with the increase of $O_2^+$ ions irradiation dose testifies to an increase of a tilt angle of the waves slopes. The comparison of Figures 1C and 1D shows that an increase of a dose of irradiation with $O_2^+$ ions does not significantly influence the ordering of an initial wavelike nanostructure obtained in $N_2^+$-GaAs system.

For the applications of the said wavelike nanostructures may become necessary to form it in the layers of an amorphous GaAs deposited onto the surface of various materials by the known method of GaAs target magnetron sputtering.

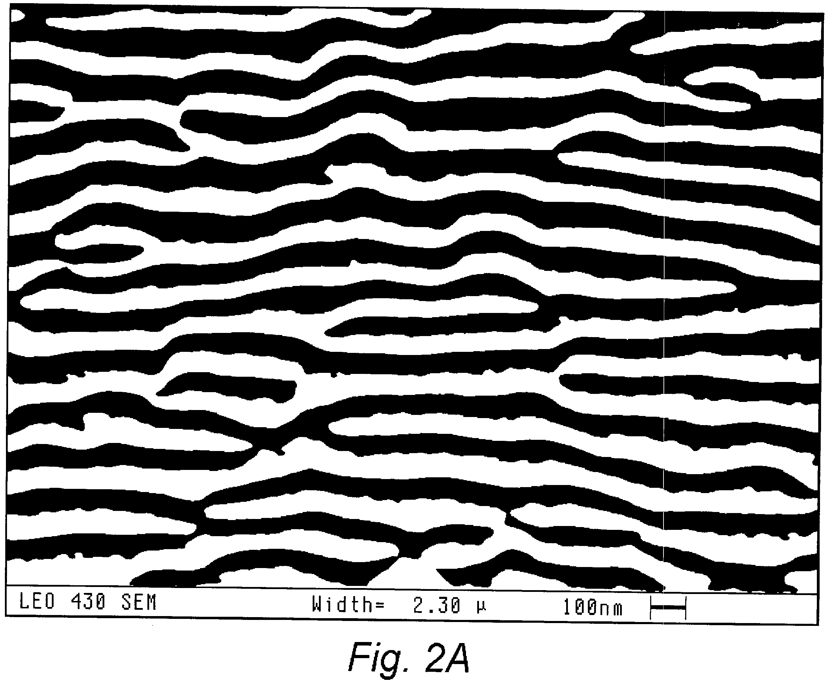

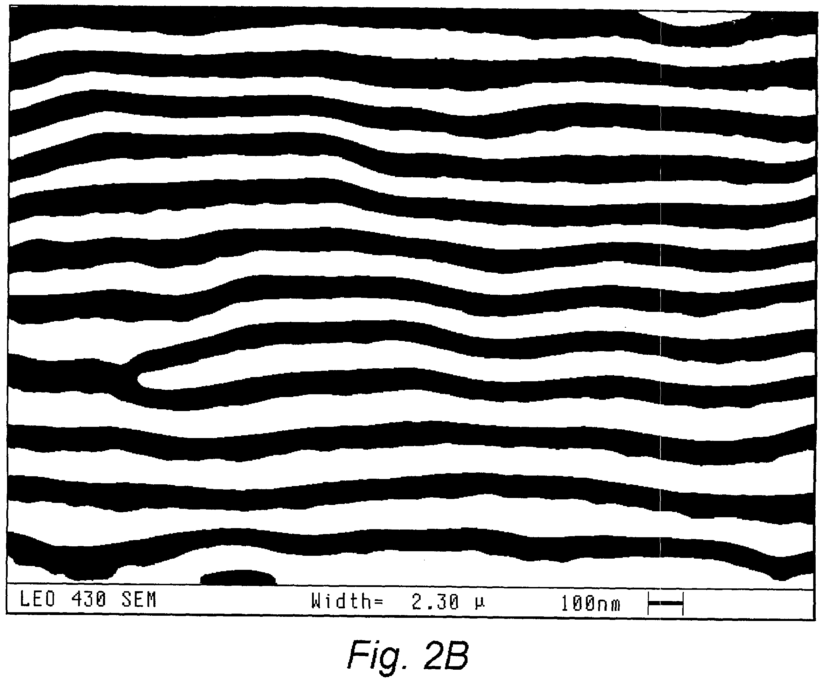

Example 2: The SEM observations of an evolution of the ripples morphology enabled one to draw a conclusion of a higher ordering of the waves in this system at a sputtering depth $D_m$. As compared to the $N_2^+$-Si system in the $O_2^+$-Si system a wavelike nanostructures form at depths of $D_m$ with a considerably less wave abruptions. The experiments for the two-stage formation of wavelike nanostructures were carried out on these grounds. At the first stage in $O_2^+$-Si system a wavelike nanostructure was formed with $\lambda$=130 nm at E=4 keV and $\theta$=47° at a sputtering depth Dm=1350 nm. The parameters for the second stage were selected to achieve equal wavelengths in $O_2^+$-Si and $N_2^+$-Si systems. At the second stage the wavelike nanostructure was sputtered with $N_2^+$ ions at E=8 keV and $\theta$=43° up to a final depth D=1670 nm. An additional sputtering depth is equal to 320 nm for $N_2^+$-Si system and corresponds to the conditions of second stage of forming of the wavelike nanostructure. The bombardment planes for $O_2^+$ and $N_2^+$ ions coincided as in Example 1. The two-stage process resulted in a wavelike nanostructure with $\lambda$=140 nm shown in Figure 2B. For a comparison purpose the Figure 2A shows the image of a wavelike nanostructure formed in a one-stage process in $N_2^+$-Si system at E=8 keV and $\theta$=43°. A statistical analysis of SEM-images with a size of 6.77 x 9 $micron^2$ was carried out by counting the number of waves in 1.3 by 6.5 $micron^2$ frames oriented by a long side perpendicular to the wave's crests and each containing 50 waves. The number of the waves passing from one long edge of the frame up to the other without abruptions and intersections (a quantity of good waves), the number of waves crossing one of the edges and but not reaching the other edge (a quantity of the wave abruptions) and the number of waves intersecting inside the frame were counted. As a result it was ascertained that a two-stage process of forming $N_2^+$- [$O_2^+$-Si] wavelike nanostructure decreases the number of the wave abruptions by 5.4 times, the wave intersections - by 2.9 times and increases the quantity of good waves by 2.4 times. Thus, it is possible to form a wavelike nanostructure using a two-stage process with improved wave ordering so that it combines increased wave longitude as in $O_2^+$-Si system at a sputtering depth $D_m$ and planarity of $N_2^+$-Si.

Example 3: In $N_2^+$+-Si system that does not possess a natural ordering property, the degree of ordering of a wavelike nanostructure can be increased by means of a preliminary mechanical processing of the silicon surface. The experiments of an oriented polishing of the silicon surface with a GOI compoundcontaining $Cr_2O_3$ particles with a subsequent formation of a wavelike nanostructure in $N_2^+$-Si system with an $N_2^+$ ion flux oriented perpendicularly to the direction of movement of abrasive particles relative to the silicon surface, have ascertained that a process of a preliminary oriented polishing leads to a considerable increase in a degree of orientation of the nanostructure along the polishing direction. The parameters for forming the nanostructure (E=8 keV, $\theta$43°, $D_F$=360 nm, $\lambda$=150 nm) are close to those used without polishing. Analogous results showing an improvement of the nanostructures orientation as a result of the preliminary polishing with GOI compoundwere obtained for the layers of amorphous silicon. One can apply a variety of water based or light alkaline slurries containing alumina or silica particles instead of a GOI paste. This class of slurry systems is used in industrial polishing of the substrates in semiconductor manufacturing.

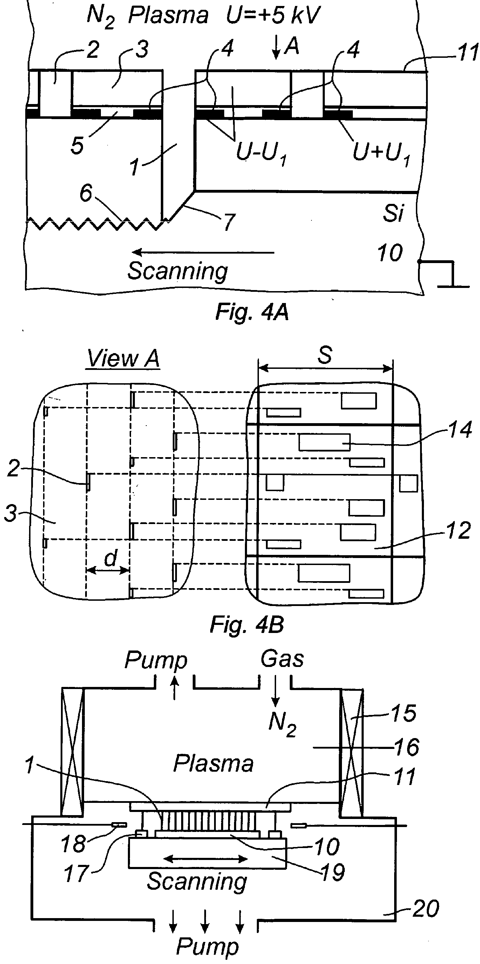

Example 4: The principle of the operation of a device for forming coherent wavelike nanostructures is illustrated by Figures 4A-4B. The device operates as follows. A substrate 10 is installed at a precision table 19. A vacuum chamber is depressurized to an operational pressure. The nitrogen is supplied through a discharge system into a plasma chamber for obtaining a nitrogen ions flux. A charge is ignited in a plasma chamber. A plasma's operational potential relative to the ground is approximately *U=+5 keV,* therefore the chamber 16 should be properly electronically insulated from chamber 20. A plasma electrode 3 has the potential *U+U1,* electrodes 4 have the potential *U-U1* when the beams are switch-on and potential *U+U1* when the beams are switched-off. The electrodes 4 are insulated from an electrode 3 by an insulator 5. Potential *U1* is in the order of +100V. The movement of a precision table 19 is controlled by means of a computer and interface and by means of the secondary electron signal detector from a test cell 17. A velocity of the table movement is decreased proportionately to a current of the secondary electron emission registered by a detector 18 from a test cell 17. A production rate of 6 substrates per hour is with the substrate is 100% covered with nanolines can be achieved under following conditions: the density of an ion current in plasma is 250 mA/cm$^2$, the velocity of a substrate movement is 2.5 mkm/s and the distance between the sheet beams is 1 mm.

The linear apertures 2 in a plasma electrode 3 are carried out along the rows with a period *d* being a whole number of times less than a size *S* of the crystal 12 on the substrate 10. This allows to completely cover the crystal with the arrays of nanolines 14 while moving over a distance in *S/d* times less than the crystal's size. The plasma electrode is made of a highly alloyed silicon substrate of n-type conductivity and of about 20 mkm thickness. A part of a former of the matrix of linear beams 11, containing electrodes 3 and 4 can be made using a planar silicon technology with implementing the electrodes bearing insulators 5 from the silicon nitride. The former's outer part 11 facing the substrate 10 is covered with a layer of amorphous silicon or a low-conductivity carbon.

In all examples of the claimed methods the ion fluxes fall obliquely upon the substrates. However, these are homogeneous ion fluxes. In case of a running sheet ion beam, as is shown in Figure 4A, an area of the sputtered surface 7 is inclined towards the ion flux's direction. As it progresses along the silicon surface 10 the beam 1 disperses the silicon and leaves behind an ordered nanostructure 6. The surface level with a nanostructure is lower than the level of the initial surface 10. The width of the obliquely sputtered area of the surface 7 is equal to the width of the beam 1. Therefore, though the ion flux 1 falls normally upon the initial surface 10, the process of forming a nanostructure 6 is carried out by a tilt bombardment of the surface of the area being sputtered.

**PREFERRED EMBODIMENT**

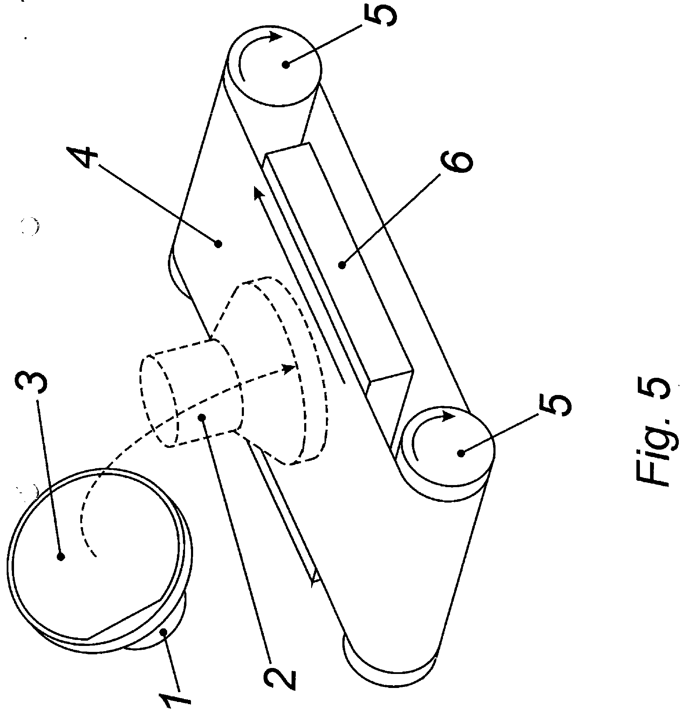

Example 5: The devices for a linear chemical - mechanical polishing are widely used for polishing substrates in the semiconductor manufacturing and contain a continuously running belt (US2002/0142704). The accomplished experiments lead to conclusion that an oriented polishing of substrates can be carried out by means of a small alteration in a design of such devices, for example, by means of eliminating a rotation of the substrate holder around its axis and providing for the holder's fixed orientation relative to a direction of the running band. Figure 5 shows a device for a directional substrates polishing. It consists of a substrate holder 1, shown in an inoperative position, designated for a substrate's installation. In an operative position 2 the holder presses the substrate 3 up to a continuous band 4, set in motion by means of rolls 5. The substrate holder provides for a fixed position of the substrate 3 relative to a direction of the band's running 4. A support 6 keeps the band 4 and the substrate holder in an operative position. The support has a system of apertures to let the compressed air through, thus providing for an even distribution of the pressure of the substrate on to the band. In addition, a polishing slurry is fed on to the band (Figure 5 does not show such a device for feeding the slurry). The rolls 5 along with a lower part of the band 4 can be submerged into a polishing slurry bath. A selection of an appropriate abrasive for the polishing slurry, for example, silica or alumina usually used in manufacturing, may prove useful for achieving a maximum coherence of a wavelike nanostructure in a consequent ion sputtering of the substrate, as it was presented in Example 3.

**The industrial application**

The invention can be used in the methods for forming patterns including those used to form patterns on the surface of the silicon and the gallium arsenide with the lines width of 10 to 60 nm, in the methods for forming nanowires for the nanoelectronics and optoelectronics devices.

**Claims**

1. A method of forming coherent wavelike nanostructures comprising:

   sputtering a surface of a semiconductor material being gallium arsenide (GaAs) with a homogeneous flow of molecular nitrogen $N_2^+$ ions to form periodic wavelike nanostructures (6) at a first depth, said wavelike nanostructures (6) having wave crests which are perpendicular to a plane of incidence of the molecular nitrogen $N_2^+$ ions;

sputtering said wavelike nanostructures (6) with a flow of molecular oxygen $O_2^+$ ions, wherein the flow of molecular oxygen $O_2^+$ ions is in a plane which coincides with the plane of incidence of the molecular nitrogen $N_2^+$ ions to increase the amplitude of the wavelike nanostructures (6).

2. The method of claim 1 wherein the semiconductor material is amorphous gallium arsenide.

3. The method of claim 2 wherein the flow of oxygen ions has energy and angle of ion incidence selected such that the wavelength of the wavelike nanostructures (6) produced by the step of sputtering with oxygen ions is the same as the wavelength produced by said step of sputtering with nitrogen ions.

4. The method of claim 2 further comprising depositing amorphous gallium arsenide using magnetron sputtering.

5. The method of claim 2 wherein the flow of nitrogen $N_2^+$ ions intersects a normal to the surface of the material at an angle in the range of 55 to 60 degrees.

6. The method of claim 5 wherein the flow of nitrogen $N_2^+$ ions has energy in the range of 6 to 8 keV.

7. The method of claim 6 wherein the gallium arsenide semiconductor material is sputtered with nitrogen $N_2^+$ ions and wherein a depth $D_F$ of the gallium arsenide sputtered with nitrogen $N_2^+$ ions does not exceed 1 micron.

8. The method of claim 2 further comprising controlling growth of amplitude of the wavelike nanostructures (6) by using a secondary-emission signal.

9. The method of claim 8 wherein the secondary-emission signal comprises electron, ion, or photon emission.

10. The method of claim 9 wherein the step of irradiating with oxygen $O_2^+$ ions is performed until the secondary-emission signal is saturated.

11. A method of forming coherent wavelike nanostructures (6) comprising:

sputtering a surface of a semiconductor material being silicon with a flow of molecular oxygen $O_2^+$ ions until low-amplitude wavelike nanostructures (6) are formed; and subsequently sputtering the surface with a flow of molecular nitrogen $N_2^+$ ions, wherein a plane of incidence of molecular nitrogen $N_2^+$ ions coincides with a plane of incidence of the molecular oxygen $O_2^+$ ions to saturate the amplitude of the wavelike nanostructures (6).

12. The method of claim 11 wherein nitrogen $N_2^+$ ions and oxygen $O_2^+$ ions have respective energies and angles of ion incidence with respect to the surface of the material so that the wavelength of the wavelike nanostructures (6) produced by said step of sputtering with oxygen $O_2^+$ ions is the same as the wavelength produced by said step of sputtering with nitrogen $N_2^+$ ions.

13. The method of claim 11 wherein the semiconductor material is amorphous silicon.

14. The method of claim 13 further comprising controlling the duration of irradiating with a flow of oxygen $O_2^+$ ions using secondary-emission signals.

15. The method of claim 14 further comprising controlling the saturation of the amplitude of the wavelike nanostructures (6), during the step of irradiating with a flow of nitrogen, with secondary-emission signals.

**Patentansprüche**

1. Verfahren zur Bildung kohärenter wellenförmiger Nanostrukturen, umfassend:

die Bestäubung einer Oberfläche eines Galliumarsenid (GaAs) darstellenden Halbleitermaterials mit einem homogenen Strom aus molekularen Stickstoff ($N_2^+$)-Ionen zur Bildung periodischer wellenförmiger Nanostrukturen (6) bei einer ersten Tiefe, wobei die wellenförmigen Nanostrukturen (6) Wellenberge aufweisen, die senkrecht zu einer Einfallsebene der molekularen Stickstoff ($N_2^+$)-Ionen verlaufen, und Bestäubung der wellenförmigen Nanostrukturen (6) mit einem Strom aus molekularen Sauerstoff ($O_2^+$)-Ionen, wobei der Strom der letzteren in einer Ebene liegt, die mit der Einfallsebene der molekularem Stickstoff ($N_2^+$)-Ionen zusammenfällt, zur Steigerung der Amplitude der wellenförmigen Nanostrukturen (6).

2. Verfahren nach Anspruch 1, wobei das Halbleitermaterial amorphes Galliumarsenid ist.

3. Verfahren nach Anspruch 2, wobei der Strom der Sauerstoffionen eine Energie und einen Winkel des Ioneneinfalls aufweist, die so ausgewählt sind, dass die Wellenlänge der wellenförmigen Nanostrukturen (6), erzeugt durch die Stufe der Bestäubung mit den Sauerstoffionen, dieselbe ist wie die Wellenlänge, die durch die Stufe der Bestäubung mit den Stickstoffionen erzeugt wird.

4. Verfahren nach Anspruch 2, das außerdem die Abscheidung von amorphem Galliumarsenid durch Magnetronzerstäubung umfasst.

5. Verfahren nach Anspruch 2, wobei der Strom der Stickstoff ($N_2^+$)-Ionen eine Normale zur Oberfläche des Materials bei einem Winkel im Bereich von 55 bis 60 Grad durchschneidet.

6. Verfahren nach Anspruch 5, wobei der Strom der Stickstoff ($N_2^+$)-Ionen eine Energie im Bereich von 6 bis 8 keV aufweist.

7. Verfahren nach Anspruch 6, wobei das Galliumarsenid Halbleitermaterial mit Stickstoff ($N_2^+$)-Ionen bestäubt wird und eine Tiefe $D_F$ des mit Stickstoff ($N_2^+$)-Ionen besprühten Galliumarsenids höchstens 1 $\mu$m beträgt.

8. Verfahren nach Anspruch 2, das außerdem noch die Steuerung der Amplitudenzunahme der wellenförmigen Nanostrukturen (6) durch ein Sekundäremissionssignal umfasst.

9. Verfahren nach Anspruch 8, wobei das Sekundäremissionssignal Elektronen-, Ionen- oder Photonenemission umfasst.

10. Verfahren nach Anspruch 9, wobei die Stufe der Bestrahlung mit Sauerstoff ($O_2^+$)-Ionen so lange durchgeführt wird, bis das Sekundäremissionssignal gesättigt ist.

11. Verfahren zur Bildung kohärenter wellenförmiger Nanostrukturen, umfassend:

die Bestäubung einer Oberfläche eines Silicum darstellenden Halbleitermaterials mit einem Strom aus molekularen Sauerstoff ($O_2^+$)-Ionen, bis wellenförmige Nanostrukturen (6) von niederer Amplitude gebildet sind, und nachfolgende Bestäubung der Oberfläche mit einem Strom von molekularen Stickstoff ($N_2^+$)-Ionen, wobei eine Einfallsebene der molekularen Stickstoff ($N_2^+$)-Ionen mit einer Einfallsebene der molekularen Sauerstoff ($O_2^+$)-Ionen zusammenfällt, zur Sättigung der Amplitude der wellenförmigen Nanostrukturen (6).

12. Verfahren nach Anspruch 11, wobei die Stickstoff ($N_2^+$)-Ionen und die Sauerstoff ($O_2^+$)-Ionen Energien bzw. Winkel des Ioneneinfalls im Hinblick auf die Oberfläche des Materials aufweisen, bei denen die Wellenlänge der wellenförmigen Nanostrukturen (6), erzeugt durch die Stufe der Besprühung mit Sauerstoff ($O_2^+$)-Ionen dieselbe ist wie die Wellenlänge, erzeugt durch die Stufe der Besprühung mit Stickstoff ($N_2^+$)-Ionen.

13. Verfahren nach Anspruch 11, wobei das Halbleitermaterial amorphes Silicium ist.

14. Verfahren nach Anspruch 13, das außerdem noch die Steuerung der Dauer der Bestrahlung mit einem Strom aus Sauerstoff ($O_2^+$)-Ionen durch Sekundäremissionssignale umfasst.

15. Verfahren nach Anspruch 14, das außerdem noch die Steuerung der Sättigung der Amplitude der wellenförmigen Nanostrukturen (6) während der Stufe der Bestrahlung mit einem Stickstoffstrom mit Sekundäremissionssignalen umfasst.

**Revendications**

1. Procédé de formation de nanostructures ondulées cohérentes comprenant :

la pulvérisation cathodique sur une surface d'un matériau semi-conducteur étant de l'arséniure de gallium (GaAs) d'un flux homogène d'ions azote moléculaire $N_2^+$ pour former des nanostructures ondulées périodiques (6) à une première profondeur, lesdites nanostructures ondulées (6) ayant des crêtes d'ondes qui sont perpendiculaires à un plan d'incidence des ions azote moléculaire $N_2^+$ ; la pulvérisation cathodique sur lesdites nanostructures ondulées (6) d'un flux d'ions oxygène moléculaire $O_2^+$, dans lequel le flux d'ions oxygène moléculaire $O_2^+$ est dans un plan qui coïncide avec le plan d'incidence des ions azote moléculaire $N_2^+$ pour augmenter l'amplitude des nanostructures ondulées (6).

2. Procédé selon la revendication 1 dans lequel le matériau semi-conducteur est de l'arséniure de gallium amorphe.

3. Procédé selon la revendication 2 dans lequel le flux d'ions oxygène a une énergie et un angle d'incidence d'ions choisis de telle sorte que la longueur d'onde des nanostructures ondulées (6) produite par l'étape de pulvérisation cathodique d'ions oxygène est la même que la longueur d'onde produite par ladite étape de pulvérisation cathodique d'ions azote.

4. Procédé selon la revendication 2 comprenant en outre le dépôt d'arséniure de gallium amorphe en utilisant une pulvérisation magnétron.

5. Procédé selon la revendication 2 dans lequel le flux

d'ions azote $N_2^+$ coupe une normale à la surface du matériau à un angle dans la plage de 55 à 60 degrés.

6. Procédé selon la revendication 5 dans lequel le flux d'ions azote $N_2^+$ a une énergie dans la plage de 6 à 8 keV.

7. Procédé selon la revendication 6 dans lequel le matériau semi-conducteur d'arséniure de gallium reçoit par pulvérisation cathodique des ions azote $N_2^+$ et dans lequel une profondeur $D_F$ de l'arséniure de gallium ayant reçu par pulvérisation cathodique des ions azote $N_2^+$ n'excède pas 1 micromètre.

8. Procédé selon la revendication 2 comprenant en outre le contrôle de croissance d'amplitude des nanostructures ondulées (6) en utilisant un signal d'émission secondaire.

9. Procédé selon la revendication 8 dans lequel le signal d'émission secondaire comprend une émission d'électrons, d'ions ou de photons.

10. Procédé selon la revendication 9 dans lequel l'étape d'irradiation avec des ions oxygène $O_2^+$ est exécutée jusqu'à ce que le signal d'émission secondaire soit saturé.

11. Procédé de formation de nanostructures ondulées (6) cohérentes comprenant :

    la pulvérisation cathodique sur une surface d'un matériau semi-conducteur étant du silicium d'un flux d'ions oxygène moléculaire $O_2^+$ jusqu'à ce que des nanostructures ondulées (6) de faible amplitude soient formées ; et
    ensuite la pulvérisation cathodique sur la surface d'un flux d'ions azote moléculaire $N_2^+$, dans lequel un plan d'incidence d'ions azote moléculaire $N_2^+$ coïncide avec un plan d'incidence des ions oxygène moléculaire $O_2^+$ pour saturer l'amplitude des nanostructures ondulées (6).

12. Procédé selon la revendication 11 dans lequel les ions azote $N_2^+$ et les ions oxygène $O_2^+$ ont des énergies et des angles d'incidence d'ions respectifs par rapport à la surface du matériau tels que la longueur d'onde des nanostructures ondulées (6) produite par ladite étape de pulvérisation cathodique d'ions oxygène $O_2^+$ est la même que la longueur d'onde produite par ladite étape de pulvérisation cathodique d'ions azote $N_2^+$.

13. Procédé selon la revendication 11 dans lequel le matériau semi-conducteur est du silicium amorphe.

14. Procédé selon la revendication 13 comprenant en outre le contrôle de la durée de l'irradiation avec un flux d'ions oxygène $O_2^+$ en utilisant des signaux d'émission secondaire.

15. Procédé selon la revendication 14 comprenant en outre le contrôle de la saturation de l'amplitude des nanostructures ondulées (6), lors de l'étape d'irradiation avec un flux d'azote, avec des signaux d'émission secondaire.

$$N_2^+$$

GaAs

8-9°

Fig. 1A

$O_2^+$

GaAs

30°

Fig. 1B

Fig. 1C

LEO 430 SEM    Width= 9.00 µ    300nm

*Fig. 1D*

LEO 430 SEM    Width= 2.30 µ    100nm

*Fig. 2A*

LEO 430 SEM          Width=  2.30 μ          100nm

*Fig. 2B*

*Fig. 3A*

Fig. 3B

$N_2$ Plasma U=+5 kV

2   3        4   ↓A   4        11

5        1   U-U_1        U+U_1

6        7        Si

7

Scanning        10

Fig. 4A

View A        S

2        14

3        12

d

Fig. 4B

Pump        Gas

$N_2$        15

16

Plasma

1        11

18        10

17        19

Scanning

20

Pump

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- RU 99124768
- EP 1104011 A1
- US 6486480 B, K.-N. Leung, H.Y. Lee, V. Ngo, N. Zahir
- RU 2180885
- US 20020142704 A

### Non-patent literature cited in the description

- **KAREN A. ; NAKAGAWA Y. ; HATADA M. ; OKINO K. ; SOEDA F. ; ISHITANI A.** Quantitave Investigation of the O2+- Induced Topography of GaAs and other III-V Semiconductors: an STM Study of the Ripple Formation and Suppression of the Secondary Ion Yield Change by Sample Rotation. *Surf. and Interf. Anal.,* 1995, vol. 23, 506-513
- **A KAREN et al.** Quantitative Investigation of the O2+-induced Topography of GaAs and Other III-V Semiconductors: an STM Study of the Ripple Formation and suppression of the Secondary Ion Yield Change by Sample Rotation. *SURFACE AND INTERFACE ANALYSIS,* 01 July 1995, vol. 23 (7-8), 506-513
- Wave-ordered structures formed on SOI wafers by reactive ion beams. **V. K. SMIRNOV et al.** NUCLEAR INSTRUMENTS & METHODS IN PHYSICS RESEARCH, SECTION - B: BEAM INTERACTIONS WITH MATERIALS AND ATOMS. ELSEVIER, 01 January 1999, vol. 147, 310-315
- **VAJO J. J. ; DOTY R. E. ; CIRLIN E. H.** Influence of O2+ energy, flux and fluency on the formation and growth of sputtering-induced ripple topography on silicon. *J. Vac. Sci. Technol.A,* 1996, vol. 14 (5), 2709-2720
- **K.L. SCOTT ; T.-J. KING ; M.A. LIEBERMAN ; K.-N. LEUNG.** Pattern generators and microcolumns for ion lithography. *Journal of Vacuum Science and Technology B,* 2000, vol. 18 (6), 3172-3176